# DEMANDE DE BREVET EUROPEEN

(11) **EP 2 429 006 A2**
(43) Date de publication de la demande: **14.03.2012**
(21) Numéro de dépôt: 11354041.3
(22) Date de dépôt: 23.08.2011
(51) Int. Cl.: H01L 33/48, H01L 33/62, H01L 23/00

(54) **Procédé de réalisation d'éléments à puce munis de rainures d'insertion de fils**

(30) Priorité: 09.09.2010 FR 1003610
(71) Demandeur: Commissariat à l'Énergie Atomique et aux Énergies Alternatives, 75015 Paris (FR)
(72) Inventeur: Brun, Jean, 38800 Champagnier (FR); Taillefer, Régis, 38420 Le Versoud (FR)
(74) Mandataire: Gris, Sébastien

(57) **Abrégé**

L'invention concerne un procédé de réalisation d'éléments à puce (10) munis d'une rainure (14), comprenant les étapes suivantes : prévoir, sur un substrat d'interconnexion (22), une piste conductrice (26) agencée pour relier une plage de contact d'une face active d'une puce (20) à une zone correspondant à une première paroi de la rainure ; faire croître par électrodéposition un plot de contact (16) sur la piste conductrice au niveau de la zone correspondant à la première paroi de la rainure ; assembler la puce (20) sur le substrat par sa face active de manière qu'une paroi latérale de la puce forme le fond de la rainure ; usiner la puce par sa face arrière parallèlement au substrat en mesurant la distance entre la face arrière de la puce et le plot de contact ; arrêter l'usinage lorsque la distance mesurée atteint une valeur souhaitée ; et assembler par collage une plaque (24) sur la face arrière de la puce de manière à former une deuxième paroi de la rainure.

## Description

### Domaine technique de l'invention

L'invention est relative à des éléments à puce microélectronique, dont la plus grande dimension peut être inférieure au millimètre, que l'on solidarise à des fils conducteurs servant, par exemple, à alimenter les puces.

### État de la technique

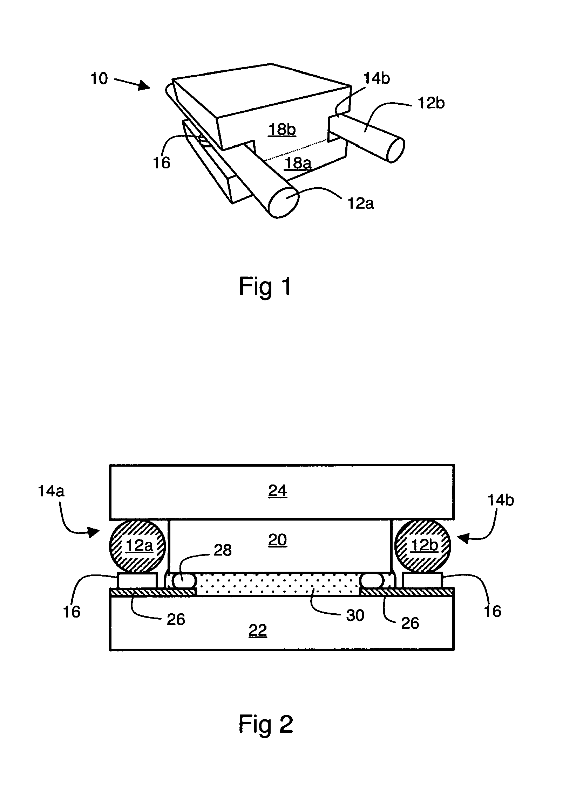

La figure 1 représente une vue en perspective d'un élément à puce 10 solidarisé à deux fils parallèles 12a et 12b, tel que décrit dans la demande de brevet WO2009112644. L'élément 10 est de forme générale parallélépipédique et deux de ses faces latérales opposées sont munies de rainures respectives parallèles 14a et 14b, qui s'étendent sur toute la longueur de l'élément 10. Chacune de ces rainures reçoit l'un respectif des fils 12a et 12b.

Les fils 12a et 12b ont généralement un rôle de connexion électrique, par exemple pour alimenter en courant électrique une diode électroluminescente formée dans la puce de l'élément 10. Ainsi, les fils 12a et 12b sont conducteurs et ils sont en connexion électrique avec la puce grâce à un plot conducteur 16 formé sur une paroi latérale de chaque rainure. La largeur des rainures et la hauteur des plots 16 sont sélectionnées en fonction du diamètre des fils 12, de manière que chaque fil soit pincé entre le plot et la paroi latérale opposée de la rainure 14.

Un élément du type de la figure 1 est généralement réalisé en deux parties. Une première partie 18a, correspondant au tiers inférieur de l'élément, est constituée de la puce. Une deuxième partie 18b, correspondant à la partie supérieure restante de l'élément, forme un capot protecteur. La face active de la puce, tournée vers le capot 18b, comporte les plots 16 et forme une première paroi latérale des rainures 14. Le capot 18b a une section en « T » lui permettant de former la deuxième paroi latérale et le fond des rainures.

Etant donné la petitesse des éléments à puce 10, l'assemblage des capots 18b sur les puces 18a pose un certain nombre de problèmes. Il est notamment difficile de respecter de manière reproductible l'écart entre les parois latérales des rainures 14. Comme le décrit la demande de brevet WO2009112644 susmentionnée, on peut souhaiter que les fils 12 soient maintenus par pincement élastique dans les rainures entre les plots 16 d'un côté, et les parois latérales opposées des rainures, de l'autre côté. Si l'écart est trop important, on ne parvient pas à pincer les fils 12. Si l'écart est trop faible, on ne parvient pas à insérer les fils dans les rainures sans casser l'élément 10.

### Résumé de l'invention

On cherche donc des moyens permettant d'assurer un écart reproductible et précis entre les parois latérales des rainures.

Pour tendre à satisfaire ce besoin, on prévoit un procédé de réalisation d'éléments à puce munis d'une rainure, comprenant les étapes suivantes : prévoir, sur un substrat d'interconnexion, une piste conductrice agencée pour relier une plage de contact d'une face active d'une puce à une zone correspondant à une première paroi de la rainure ; faire croître par électrodéposition un plot de contact sur la piste conductrice au niveau de la zone correspondant à la première paroi de la rainure ; assembler la puce sur le substrat par sa face active de manière qu'une paroi latérale de la puce forme le fond de la rainure ; usiner la puce par sa face arrière parallèlement au substrat en mesurant la distance entre la face arrière de la puce et le plot de contact ; arrêter l'usinage lorsque la distance mesurée atteint une valeur souhaitée ; et assembler par collage une plaque sur la face arrière de la puce de manière à former une deuxième paroi de la rainure.

Selon un mode de mise en oeuvre du procédé, l'étape d'assemblage comprend les étapes suivantes : appliquer une quantité de colle polymérisable sur la face arrière de la puce à une température de liquéfaction de la colle ; appliquer la plaque sur la puce avec une pression propre à obtenir une épaisseur minimale de colle entre la plaque et la puce en chassant le surplus de colle ; et porter la colle à une température de polymérisation en maintenant la pression.

Selon un mode de mise en oeuvre du procédé, la plaque ou la face arrière de la puce est munie de cavités propres à recueillir un surplus de colle chassé par la pression.

Selon un mode de mise en oeuvre, le procédé comprend les étapes suivantes : déposer un fond continu conducteur, favorisant l'électrodéposition, recouvrant le substrat et la piste conductrice ; faire croître par électrodéposition des micro-inserts sur le fond continu au niveau de la piste conductrice en correspondance avec la plage de contact de la face active de la puce ; faire croître le plot de contact sur le fond continu ; retirer le surplus de fond continu ; et assembler la puce sur le substrat de manière que sa plage de contact vienne en appui sur les micro-inserts.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- la figure 1, précédemment décrite, représente une vue en perspective d'un élément à puce solidarisé à deux fils ;
- la figure 2 représente une vue de face d'un mode de réalisation d'élément à puce comprenant une puce connectée par sa face active à un substrat d'interconnexion ; et
- les figures 3a à 3e représentent des étapes de réalisation d'un élément à puce du type de la figure 2.

### Description d'un mode de réalisation préféré de l'invention

La figure 2 représente un mode de réalisation d'élément à puce d'un type particulier pour lequel on cherche à améliorer la précision de la largeur des rainures.

Dans cet élément à puce, la puce 20 est reliée directement par sa face active, c'est-à-dire la face où sont réalisés les circuits, sur un substrat d'interconnexion 22, selon la technique couramment désignée par le terme anglais « flip-chip ». Ainsi, les parois latérales de la puce 20 forment le fond des rainures 14a et 14b, et les parties du substrat 22 en saillie par rapport à la puce forment une première paroi des rainures. La deuxième paroi, opposée, des rainures est formée par des parties en saillie d'une plaque 24 fixée par collage sur la face arrière de la puce 20.

Le substrat 22 comprend sur sa face supérieure des pistes conductrices 26 destinées à relier des plages de contact de la puce 20 à des plots 16 respectifs disposés sur la première paroi des rainures 14. Les plages de contact de la puce 20 sont connectées aux pistes 26 à l'aide de billes de soudure 28 ou tout autre moyen adapté à la technique du « flip-chip ». Ces billes de soudure assurent en même temps le maintien de la puce. Un matériau d'enrobage 30 remplit l'espace entre la puce 20 et le substrat 22 et noie les billes 28.

Comme cela est représenté, les fils 12a et 12b sont de préférence pincés entre les plots 16 et les parois opposées des rainures 14, c'est-à-dire les parois définies par la plaque 24. Comme on l'a précédemment mentionné, si l'écart entre les plots et les parois opposées est trop important, on ne parvient pas à pincer les fils 12. Si l'écart est trop faible, on ne parvient pas à insérer les fils dans les rainures sans casser l'élément. Ainsi, le procédé d'assemblage de l'élément à puce doit garantir une précision suffisante de cet écart.

La chaîne de cotes entre un plot 16 et la paroi opposée de la rainure comprend de nombreux éléments, notamment le plot 16, la bille de soudure 28, la puce 20, et la couche de colle entre la puce 20 et la plaque 24. La somme d'incertitudes dimensionnelles de tous ces éléments ne permet pas, sans précautions particulières, d'atteindre la précision souhaitée de manière reproductible.

On propose ici des choix particuliers dans le procédé de réalisation permettant d'atteindre la précision souhaitée de manière reproductible. En particulier, les plots de contact 16 sont réalisés par électrodéposition. La hauteur des plots, bien qu'elle ne soit pas précise par ce procédé, a la propriété d'être uniforme sur l'ensemble d'une plaquette traitée. Après montage de la puce sur son substrat, elle est meulée par sa face arrière en mesurant la hauteur entre le plot et la face arrière. Le meulage est arrêté lorsque la mesure correspond à la dimension souhaitée. La mesure est effectuée de manière classique à l'aide d'un comparateur ou d'un profilomètre. La plaque 24 est ensuite collée sur la face arrière de la puce 20, avec un procédé permettant d'obtenir une couche de colle d'épaisseur minimale.

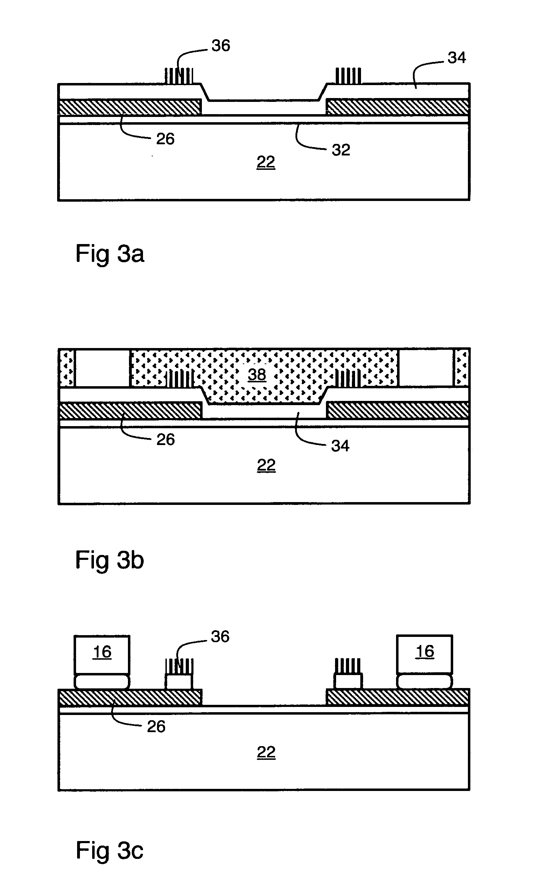

Les figures 3a à 3e représentent diverses étapes dans un procédé de réalisation d'éléments à puce du type de la figure 2. Ce procédé est applicable à la réalisation de plusieurs éléments à puce sur une plaquette de silicium destinée à former les substrats d'interconnexion 22 des éléments à puce.

A la figure 3a, le substrat 22, par exemple en silicium, est recouvert d'une couche isolante pleine plaque 32 en oxyde de silicium, sur laquelle on a formé les pistes conductrices 26, par exemple en aluminium. Un fond continu pleine plaque 34, destiné à favoriser l'électrodéposition, par exemple en alliage de titane et de cuivre, recouvre les pistes conductrices.

Des micro-inserts 36, destinés à réaliser les contacts avec la puce, ont été formés par électrodéposition sur le fond continu 34, au niveau des parties adéquates des pistes conductrices 26. Cela constitue une alternative avantageuse aux billes de soudure pour connecter la puce au substrat. En effet, cette solution permet d'obtenir une interface plus mince (entre 2 et 10µm) et donc moins sensible à l'humidité (la surface d'échange latérale étant plus faible).

A la figure 3b, on forme les plots 16 par électrodéposition. Pour cela, une couche de résine réticulable 38 est déposée sur le fond continu 34, puis insolée et gravée pour retirer la résine aux emplacements des plots. On fait croître les plots dans ces emplacements par électrodéposition sur le fond continu 34. La hauteur des plots dépend du temps d'électrodéposition. L'épaisseur de la résine n'a aucune influence - elle doit simplement être supérieure à la hauteur souhaitée des plots 16.

L'électrodéposition est effectuée de préférence avec deux matériaux. On commence par déposer une couche de nickel, par exemple sur 15 µm, et on finit par une couche d'or, par exemple sur 3 µm, pour favoriser le contact avec les fils 12 (figure 2).

A la figure 3c, la résine et le fond continu 34 en surplus sont retirés. Subsistent alors les plots 16 et les micro-inserts 36 sur des îlots du matériau du fond continu, en contact électrique avec les pistes 26.

Les plots 16, bien que leur hauteur ne puisse pas être obtenue avec la précision souhaitée, sont de hauteur uniforme sur l'ensemble de la plaquette traitée.

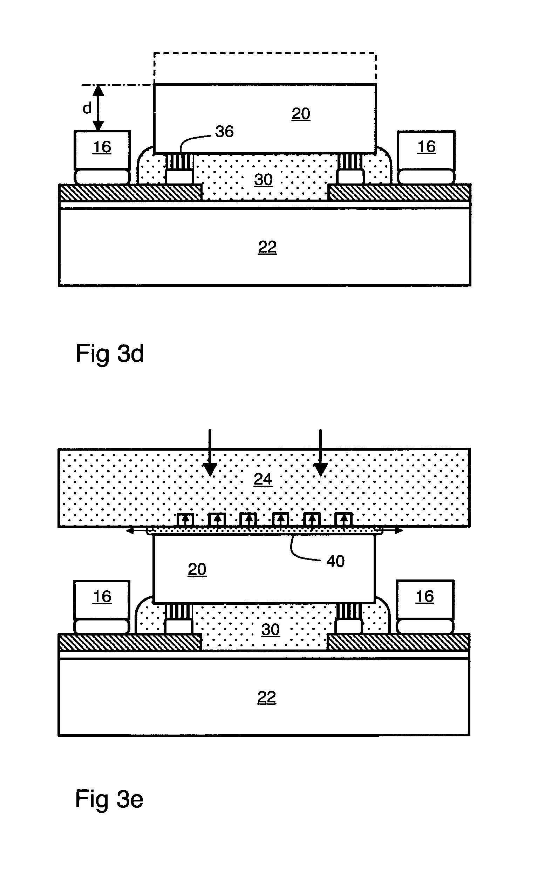

A la figure 3d, la puce 20 est assemblée sur le substrat 22, les plages de contact de sa face active étant appliquées sur les micro-inserts 36. Les contacts sont établis en exerçant une pression suffisante sur la puce pour que les micro-inserts pénètrent partiellement dans les plages de contact de la puce. Le matériau d'enrobage 30 est apporté dans l'espace entre la puce 20 et le substrat 22. Ce matériau d'enrobage, assurant ici également la fixation de la puce sur le substrat, est de préférence une colle ou une résine polymérisable.

La hauteur de la puce 20 est ensuite diminuée depuis sa face arrière par meulage, ou toute autre forme adéquate d'usinage. La hauteur initiale de la puce est représentée en pointillés. Pendant la phase de meulage, on mesure la distance entre la face arrière de la puce et le sommet des plots 16. Le meulage est arrêté lorsque la distance d souhaitée est atteinte. Cette distance correspond au diamètre du fil 12 à insérer dans les rainures. Les outils d'usinage actuels permettent de contrôler une telle distance et de la respecter avec une précision amplement suffisante pour les besoins décrits ici.

A la figure 3e, la plaque 24, par exemple en verre, est rapportée sur la face arrière de la puce 20 par collage. On souhaite que le joint de colle 40 soit d'une épaisseur minimale, de sorte que ses dispersions influent peu sur la distance finale obtenue entre les plots 16 et la plaque 24. Pour cela, on procède à un collage par thermocompression.

Une goutte de colle (par exemple époxy E505 - EPOTECNY) convenablement dosée est déposée sur la face arrière de la puce 20, ou bien une couche uniforme est déposée à la tournette sur la plaque 24. De préférence, le dosage de colle est tel qu'elle recouvre la totalité de la face supérieure de la puce 20 sans toutefois déborder sur les plots 16 après collage.

La plaque 24 est appliquée sur la puce 20 sous une pression suffisante pour chasser une grande partie de la colle vers les bords de la puce. La pression est maintenue pendant la phase de durcissement de la colle, qui comporte de préférence deux paliers de température. Un premier palier, entre 50 et 90° C pendant 10 à 30 min pour la résine E505, est destiné à liquéfier la colle et faciliter sa migration. Un deuxième palier, au dessus de 90° pendant 10 à 60 min, est destiné à polymériser la colle.

Pour faciliter davantage la réduction de l'épaisseur du joint de colle, comme cela est représenté, des cavités sont prévues dans la face inférieure de la plaque 24. De telles cavités, par exemple sous forme de rainures réalisées à la scie, pourront également être prévues sur la face arrière de la puce 20. Ces cavités, en accumulant les surplus de colle, permettent de raccourcir le trajet de migration de la colle chassée.

Avec ces différentes mesures, on obtient une épaisseur du joint de colle de l'ordre de 1 *µ*m, reproductible avec une tolérance dimensionnelle nettement inférieure à celle requise pour l'écart entre les plots 16 et la plaque 24.

On remarque que les différentes étapes des figures 3a à 3e, bien que décrites en relation avec une seul élément à puce, s'appliquent avantageusement à une matrice d'éléments à puce réalisés à partir d'une plaquette formant les substrats 20. L'opération de meulage s'effectue sur l'ensemble des puces 20 assemblées. La plaque 24, de la dimension de la matrice, est appliquée sur l'ensemble des puces 20. Les éléments à puce sont finalement désolidarisés par sciage.

## Revendications

1. Procédé de réalisation d'éléments à puce (10) munis d'une rainure (14), comprenant les étapes suivantes :
• prévoir, sur un substrat d'interconnexion (22), une piste conductrice (26) agencée pour relier une plage de contact d'une face active d'une puce (20) à une zone correspondant à une première paroi de la rainure ;
• faire croître par électrodéposition un plot de contact (16) sur la piste conductrice au niveau de la zone correspondant à la première paroi de la rainure ;
• assembler la puce sur le substrat par sa face active de manière qu'une paroi latérale de la puce forme le fond de la rainure ;
• usiner la puce par sa face arrière parallèlement au substrat en mesurant la distance entre la face arrière de la puce et le plot de contact ;
• arrêter l'usinage lorsque la distance mesurée atteint une valeur souhaitée ; et
• assembler par collage une plaque (24) sur la face arrière de la puce de manière à former une deuxième paroi de la rainure.

2. Procédé selon la revendication 1, dans lequel l'étape d'assemblage comprend les étapes suivantes :
• appliquer une quantité de colle polymérisable sur la face arrière de la puce à une température de liquéfaction de la colle ;
• appliquer la plaque sur la puce avec une pression propre à obtenir une épaisseur minimale de colle entre la plaque et la puce en chassant le surplus de colle ; et
• porter la colle à une température de polymérisation en maintenant la pression.

3. Procédé selon la revendication 2, dans lequel la plaque ou la face arrière de la puce est munie de cavités propres à recueillir un surplus de colle chassé par la pression.

4. Procédé selon la revendication 1, comprenant les étapes suivantes :
• déposer un fond continu conducteur (34), favorisant l'électrodéposition, recouvrant le substrat et la piste conductrice ;
• faire croître par électrodéposition des micro-inserts (36) sur le fond continu au niveau de la piste conductrice en correspondance avec la plage de contact de la face active de la puce ;
• faire croître le plot de contact sur le fond continu ;
• retirer le surplus de fond continu ; et
• assembler la puce sur le substrat de manière que sa plage de contact vienne en appui sur les micro-inserts.
